## Europäisches Patentamt
## European Patent Office
## Office européen des brevets

(19)

(11) Veröffentlichungsnummer : **0 101 612**
**B1**

(12) **EUROPÄISCHE PATENTSCHRIFT**

(45) Veröffentlichungstag der Patentschrift :
**01.02.89**

(21) Anmeldenummer : **83108149.2**

(22) Anmeldetag : **17.08.83**

(51) Int. Cl.⁴ : **H 03 B   9/14**

(54) **Oszillator mit einem Zweipol als aktivem Element.**

(30) Priorität : **19.08.82 DE 3230830**

(43) Veröffentlichungstag der Anmeldung :
**29.02.84 Patentblatt 84/09**

(45) Bekanntmachung des Hinweises auf die Patenterteilung : **01.02.89 Patentblatt 89/05**

(84) Benannte Vertragsstaaten :
**DE FR GB IT NL SE**

(56) Entgegenhaltungen :
**US—A— 3 599 118**
**12th EUROPEAN MICROWAVE CONFERENCE, 13.-17.
September 1982, Helsinki, Finland, Seiten 687-690; K.
ERICHSEN u.a.: "MM-wave fin-line oscillator with
electronic matching and tuning"**
**IEEE TRANSACTIONS ON MICROWAVE THEORY
AND TECHNIQUES, Band MTT-18, Nr. 11, November
1970, Seiten 827-834, IEEE, New York, US; J.F. REY-
NOLDS u.a.: "Microwave circuits for high-efficiency
operation of transferred electron oscillators"**
**11th EUROPEAN MICROWAVE CONFERENCE, 7.-11.
September 1981, Amsterdam, Holland, Seiten 301-
304; HADIA EL HENNAWY u.a.: "Octave-band fin-line
hybrid"**

(73) Patentinhaber : **ALCATEL N.V.**
**Strawinskylaan 537 (World Trade Center)
NL-1077 XX Amsterdam (NL)
FR GB IT NL SE
Standard Elektrik Lorenz Aktiengesellschaft
Hellmuth-Hirth-Strasse 42
D-7000 Stuttgart 40 (DE)
DE**

(72) Erfinder : **Szabo, Laszlo, Dr.-Ing.
Tubizer Strasse 11
D-7015 Korntal (DE)**
Erfinder : **Schünemann, Klaus, Prof. Dr.-Ing.
Starenweg 79
D-3300 Braunschweig (DE)**

(74) Vertreter : **Graf, Georg Hugo, Dipl.-Ing. et al
Standard Elektrik Lorenz AG Patent- und Lizenzwesen Postfach 30 09 29
D-7000 Stuttgart 30 (DE)**

EP 0 101 612 B1

## EP 0 101 612 B1

**Beschreibung**

Die Erfindung geht aus von einem Oszillator wie im Oberbegriff des Anspruchs 1. Ein solcher Oszillator ist aus dem Aufsatz « Entwurfskriterien für elektronisch durchstimmbare Oszillatoren in Hohlleitertechnik » von L. Szabo et al in Mikrowellen Magazin 3/78, Seiten 193-202 bekannt.

Bei Oszillatoren ist es häufig erwünscht, die Frequenz und/oder die vom Oszillator abzugebende Leistung zu verändern. Bei den bekannten Oszillatoren hat eine Änderung der Frequenz stets auch eine Änderung der Leistung und umgekehrt zur Folge.

Aufgabe der Erfindung ist es, einen Oszillator anzugeben, bei dem die Einstellung/Durchstimmung der Parameter, die die Frequenz bzw. Leistung bestimmen, eine nur minimale Auswirkung auf die jeweils nicht neu eingestellte/durchgestimmte Leistung bzw. Frequenz haben.

Die Lösung dieser Aufgabe erfolgt mit den im Anspruch 1 angegebenen Mitteln. Vorteilhafte Ausgestaltungen sind den Unteransprüchen zu entnehmen.

Der neue Oszillator eignet sich besonders als Oszillator, der in Frequenz und Amplitude modulierbar ist. Die Durchstimmung und die Anpassung an die Last erfolgen rein elektronisch, d. h. es sind keine mechanischen Einstellungen notwendig. Bei Frequenzen oberhalb von 15 GHz kann der Koppler gemäß einer Ausgestaltung in Flossenleitungstechnik realisiert sein. Dies ermöglicht eine räumlich kompakte, robuste und preiswerte Realisierung des gesamten Oszillators bei kleinen geometrischen Toleranzempfindlichkeiten.

Die Erfindung wird anhand der Zeichnungen beispielsweise näher erläutert. Es zeigt :

Fig. 1 Blockschaltbild eines Ausführungsbeispiels, und

Fig. 2 die Realisierung des Kopplers in Flossenleitungstechnik.

Bei dem Ausführungsbeispiel ist als Impedanztransformationsnetzwerk zur Anpassung des Oszillators an eine Last ein Koppler 4 mit vier Anschlüssen 2, 3, 7, 8 vorgesehen. An die beiden ersten Anschlüsse 7, 8 sind jeweils Varakter-Dioden 5,6 angeschlossen. Die eine Varakterdiode 5 wird zur Einstellung der Frequenz, die andere 6 zur Einstellung der Leistung verwendet. Wird keine Durchstimmbarkeit bzw. keine Modulation gewünscht, dann wird an beide Varakterdioden eine solche Vorspannung angelegt, daß man die gewünschten Werte erhält.

Soll der Oszillator durchstimmbar bzw. modulierbar sein, dann werden zur Steuerung der Frequenz bzw. der Leistung die Vorspannungen für die Varakterdioden geeignet geändert.

Da die beiden Vorspannungen für die beiden Dioden voneinander unabhängig gesteuert werden können, ist die Frequenzeinstellung von der Leistungseinstellung entkoppelt.

An einen weiteren Anschluß 2 des Kopplers ist ein aktiver Zweipol angeschlossen. Als aktives Element hierfür eignet sich eine Gunn-Diode.

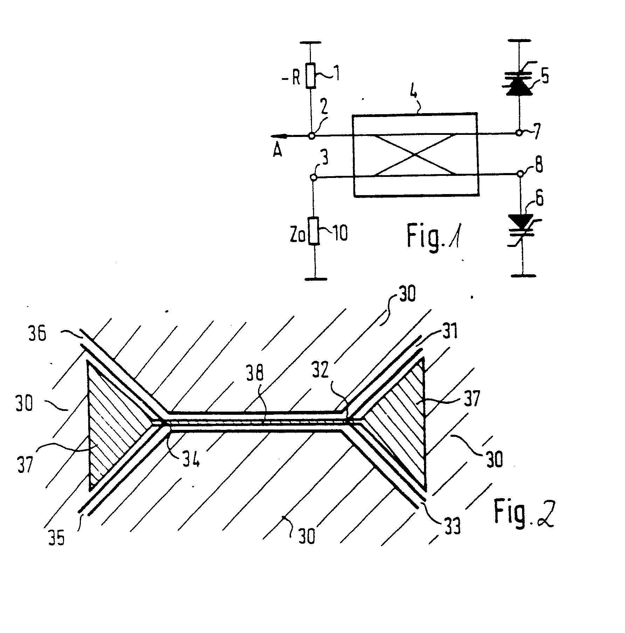

Bei dem Ausführungsbeispiel gemäß Fig. 1 ist der vierte Anschluß 3 des Kopplers mit einer Impedanz 10 abgeschlossen. Die Impedanz Zo ist so gewählt, daß sie gleich dem Wellenwiderstand des Kopplers ist. In diesen Fall ist der Anschluß 2 des Kopplers nicht nur mit dem aktiven Zweipol verbunden, sondern dieser Anschluß ist gleichzeitig auch der Ausgang A des Oszillators.

Der neue Oszillator läßt sich in vorteilhafter Weise integriert auf einem Substrat realisieren. Besonders geeignet hierzu ist die Realisierung in Flossenleitungstechnik.

Die Flossenleitungstechnik (Flossenleitungen sind im englischen Sprachgebrauch fine line genannt) an sich ist bekannt, z. B. aus Wissenschaftliche Berichte AEG-Telefunken, 54(1981) 4-5, Seite 219. Bei der Flossenleitungstechnik ist im Innern eines Hohlleiters ein dielektrisches Substrat vorgesehen, auf das metallische Flossen aufgebracht sind. Die metallischen Flossen bilden einen Schlitz.

Nachfolgend wird anhand der Fig. 2 ein neuer Koppler auf der Basis von Zweigleitungskopplern (branch-line coupler) in Flossenleitungstechnik beschrieben. Die Flossenleitung ist unilateral, d. h. es sind nur auf einer Seite des Substrats metallische Flossen 30 auf das Substrat aufgebracht. Die Flossen sind in der Zeichnung durch eine Schraffur (von links unten nach rechts oben) gekennzeichnet. Die Flossen bilden Schlitze 31, 33, 35 und 36.

Der Schlitz zwischen den Punkten 32 und 34, an denen jeweils zwei unilaterale Flossenleitungen zusammentreffen, ist von seinem elektrischen Verhalten her kein Schlitz einer Flossenleitung sondern er bildet an sich eine Schlitzleitung.

Die beschriebene Flossenleitung stellt erst dann einen Koppler dar, wenn sie durch geeignet angeordnete quasikonzentrierte Elemente ergänzt wird. Hierzu ist geeignet :

ein Drahtstück (in der Fig. 2 nicht dargestellt), das an den Spitzen 32 und 34 auf die Flossen aufgebondet ist und somit diese beiden Spitzen verbindet. Das Drahtstück hat die Form eines U, dessen Schenkel senkrecht zur Flossenoberfläche stehen und mit den Spitzen verbunden sind. Der zur Flossenoberfläche parallel angeordnete Teil des Drahtstücks soll von den Flossen einen möglichst großen Abstand haben, damit das elektrische Feld der Flossenleitung möglichst wenig beeinflußt wird. Seine optimale Länge ist durch die erforderliche 90°-Phasenverschiebung zwischen den beiden Koppelarmen 31, 33 bestimmt.

ein auf der den Flossen gegenüberliegenden Seite des Substrats angeordneter Streifenleiter 38. Der Streifenleiter verläuft über dem Schlitz zwischen den Spitzen 32 und 34. Jeweils seitlich dieser Spitzen ist der Streifenleiter zu einer Metallfläche 37 aufgeweitet. Diese Metallflächen bilden mit den jeweils auf der anderen Substratseite angeordneten Flossen eine kapazitive Kopplung. Die Länge der Streifenleitung bestimmt die Entkopplung. Der Streifenleiter hat im allgemeinen keine geraden sondern einen schlangenförmigen Verlauf, um, wie im vorhergehenden Fall, die 90°-Phasenverschiebung zu gewährleisten. Dadurch und weil die kapazitive Kopplung die elektrische Länge des Streifens beeinflußen kann diesem eine gewünschte elektrische Länge gegeben werden. Bei seiner Anordnung muß darauf geachtet werden, daß das elektrische Feld der Flossenleitung möglichst nicht beeinflußt wird und daß durch ihn keine bilaterale Flossenleitung gebildet wird.

Das Koppelverhältnis, d. h. das Verhältnis, in dem die über eine Flossenleitung zugeführte Energie auf die beiden Flossenleitungen, über die diese Energie weitergeleitet wird, aufgeteilt wird, hängt unter anderem davon ab, wie stark die Flossenleitungen in ihrer Längsrichtung räumlich gegeneinander versetzt sind.

Durch die Wahl das Koppelverhältnis kann man die Empfindlichkeit der Einstellparameter, d. h. die Empfindlichkeit der Frequenz bzw. Amplitudeneinstellung, einstellen.

Bei der Realisierung in Flossenleitungstechnik sind die Varakterdioden 5, 6 direkt über die Schlitze, die durch die Flossenleitungen gebildet werden, gebondet.

Die Flossenleitungen enden nach den Varakterdioden mit Kurzschlüssen. Das aktive Element, die Gunn-Diode, wird auf entsprechende Weise auf die Flossen eines anderen Flossenleitungsstücks aufgebondet.

Eine große gewünschte Bandbreite erhält man dann, wenn man das Flossenleitungsstück hinter der Gunn-Diode mit einer geeigneten Impedanz abschließt. Ist die Flossenleitung mit einem Kurzschluß abgeschlossen, dann ist die Bandbreite gegenüber der anderen Lösung eingeschränkt.

Nachfolgend noch einige Bemerkungen zur Funktionsweise. Betrachtet man von der Gunn-Diode aus (Schlitz 35, Fig. 2) den Eingangsreflexionswiderstand $r_{in}$, der von den Reflexionskoeffizienten $r_2$, $r_3$ der Varaktor-Dioden (an den Schlitzen 36 und 33, Fig. 2) abhängt, dann ist dieser

$$r_{in} = \frac{\left(1 - \frac{1}{C}\right)}{r_2} + \frac{r_3}{C}$$

(C ist der Koppelfaktor des Kopplers). Diese Relation kann in einem Smith-Diagramm dargestellt werden. Man sieht, daß $r_2$ nur die Phase von $r_{in}$ während $r_3$ fast ausschließlich die Amplitude von $r_{in}$ beeinflußt. Bei einem 10dB-Koppler ändert sich die Amplitude zwischen 0,8 und 1,0 und die Phase um 12 Grad. Es kann also durch Steuerung der einen Varaktor-Diode die Phase und somit die Frequenz und mit der anderen Varakterdiode die Leistung des Oszillators eingestellt werden.

## Patentansprüche

1. Oszillator für elektromagnetische Wellen mit einem Zweipol (1) als aktivem Element und einem Impedanztransformationsnetzwerk (4) zur Anpassung des Zweipols an eine Last (A), dadurch gekennzeichnet, daß das Impedanztransformationsnetzwerk gebildet wird durch einen Koppler (4) mit vier Anschlüssen (2, 3, 7, 8), daß zwei Anschlüsse (7, 8) mit Impedanzen zur Einstellung/Durchstimmung der Leistung bzw. Frequenz abgeschlossen sind, daß ein weiterer Anschluß (3) mit einer weiteren Impedanz (10), die gleich dem Wellenwiderstand des Kopplers ist, abgeschlossen ist, und daß der vierte Anschluß (2) einerseits mit dem Zweipol (1) verbunden und andererseits der Oszillatorausgang (A) ist.

2. Oszillator nach Anspruch 1, dadurch gekennzeichnet, daß die mit den beiden ersten Anschlüssen (7, 8) verbundenen Impedanzen (5, 6) voneinander unabhängig durchstimmbar sind.

3. Oszillator nach Anspruch 1 oder 2, dadurch gekennzeichnet, daß der Koppler in Flossenleitungstechnik realisiert ist.

4. Oszillator nach Anspruch 3, dadurch gekennzeichnet, daß der aktive Zweipol und die Impedanzen über Flossenleitungen mit dem Koppler verbunden sind.

5. Oszillator nach einem der Ansprüche 2 bis 4, dadurch gekennzeichnet, daß die durchstimmbaren Impedanzen Varakterdioden sind.

## Claims

1. Oscillator for electromagnetic waves, comprising a two-terminal device (1) as an active element and an impedance-matching network (4) for matching the two-terminal device to a load (A), characterized in that the impedance-matching network is formed by a coupler (4) having four terminals (2, 3, 7, 8), that two of the terminals (7, 8) are terminated with impedances for adjusting/continuously varying the output power and the frequency, that another one of the terminals (3) is terminated with a further impedance (10) equal to the characteristic impedance of the coupler, and that the fourth terminal (2) is connected to the two-terminal device (1) on the one hand and to the oscillator output (A) on the other hand.

2. An oscillator as claimed in claim 1, characterized in that the impedances (5, 6) connected to the first two terminals (7, 8) are continuously variable independently of each other.

3. An oscillator as claimed in claim 1 or 2, characterized in that the coupler is implemented in fin-line form.

4. An oscillator as claimed in claim 3, characterized in that the active two-terminal device and the impedances are connected to the coupler via fin lines.

5. An oscillator as claimed in any one of claims 2 to 4, characterized in that the continuously variable impedances are varactor diodes.

## Revendications

1. Oscillateur pour ondes électromagnétiques comprenant un dipôle (1) comme élément actif et un réseau d'adaptation d'impédance (4) pour adapter ledit dipôle à une charge (A), caractérisé en ce que le réseau d'adaptation d'impédance est formé par un coupleur (4) ayant quatre accès (2, 3, 7, 8), en ce que deux accès (7, 8) sont terminés par des impédances (5, 6) pour un réglage/ajustement continu de la puissance de sortie et de la fréquence, en ce qu'un autre accès (3) est connecté à une autre impédance (10), égale à l'impédance caractéristique du coupleur, et en ce que le quatrième accès (2), d'une part, est connecté audit dipôle actif (1) et, d'autre part, (3) est la sortie (A) de l'oscillateur.

2. Oscillateur conforme à la revendication 1, caractérisé en ce que les impédances (5, 6) connectées aux deux premiers accès (7, 8) sont variables de façon continue, indépendamment l'une de l'autre.

3. Oscillateur conforme à la revendication 1 ou 2, caractérisé en ce que le coupleur est réalisé sous la forme de lignes dites « en nageoire ».

4. Oscillateur conforme à la revendication 3, caractérisé en ce que le dipôle actif et les impédances sont connectés au coupleur par des lignes dites « en nageoire ».

5. Oscillateur conforme à l'une des revendications 2 à 4, caractérisé en ce que les impédances variables de façon continue sont des diodes à capacité variable.

EP 0 101 612 B1

Fig. 1

Fig. 2